# EUROPEAN PATENT SPECIFICATION

(11) **EP 4 048 043 B1**
(45) Date of publication and mention of the grant of the patent: **07.10.2026**
(21) Application number: 19949009.5
(22) Date of filing: 18.10.2019
(51) Int. Cl.: H05K 13/02, H05K 13/00, H05K 13/08, B65G 1/04

(54) **STORAGE CONTAINER**
AUFBEWAHRUNGSBEHÄLTER
RÉCIPIENT DE STOCKAGE

(43) Date of publication of application: 24.08.2022
(73) Proprietor: Fuji Corporation, Chiryu-shi, Aichi 472-8686 (JP)
(72) Inventor: ITO Akinobu, Chiryu-shi, Aichi 472-8686 (JP)
(74) Representative: Grünecker Patent- und Rechtsanwälte PartG mbB
(86) International application number: PCT/JP2019/041123
(87) International publication number: WO 2021/075049

(56) References cited:
- EP-A1- 1 627 830
- EP-A1- 3 238 514
- EP-B1- 3 238 514
- WO-A1-2019/142336
- JP-A- 2018 501 167
- JP-A- H04 298 402
- US-A1- 2017 073 159

## Description

### Technical Field

This specification discloses technology related to a storage compartment.

### Background Art

The storage device described in Patent Reference 1 is provided with a reel storage compartment, a storage space, and a moving section. The reel storage compartment stores a reel around which is wound component tape storing components. The storage space is provided in the reel storage compartment and stores an object such as a reel. The moving section moves a reel to a given storage space to store the reel, and moves a reel stored in a storage space to an unloading aperture of the reel storage compartment to unload the reel. Patent Reference 2, Patent Reference 3 and Patent Reference 4 provide further storage compartments according to the prior art.

### Citation List

### Patent References

Patent Reference 1: International JP-A-2019-142336
Patent Reference 2: EP 3 238 514 A1
Patent Reference 3: EP 1627 830 A1
Patent Reference 4: WO 2019 142336 A1

### Summary of Invention

### Technical Problem

A storage device described in Patent Reference 1 is provided with a moving section which automatically stores a reel that was loaded into a storage space. The storage device described in Patent Reference 1 is provided with a reading device at the loading aperture of a reel storage compartment. When the reel is loaded into the reel storage compartment, the reading device reads identifying information recorded in identification media attached to the reel. This enables the storage device described in Patent Reference 1 to identify the reel loaded into the reel storage compartment. However, Patent Reference 1 does not describe acquiring the external dimensions of the reel to be loaded into the reel storage compartment, and there is a need for a storage compartment able to acquire the external dimensions of an object, such as a reel, that will be used by a board work machine.

A storage compartment disclosed in this specification meets this need by automatically storing loaded objects in a storage section and enabling the acquisition of the external dimensions of an object to be used by a board work machine.

### Solution to Problem

The invention is set out in the appended set of claims. This specification discloses a storage compartment provided with a loading section configured to allow at least loading of an object used by a board work machine to perform given board work on a board; the object being a reel around which a component tape housing components is wound, a dimension acquiring section that is configured to acquire the external dimensions of the object loaded in the loading section, multiple types of storage sections configured to store objects of varying external dimensions, and a moving section that is configured to move the object loaded in the loading section to the storage section, further comprising a first measuring device configured to measure the height dimension of the object loaded in the loading section the measurement taken from the side of the object, wherein the dimension acquiring section causes the first measuring device to measure the height dimension of the object loaded in the loading section, and acquires the height dimension of the object measured by the first measuring device, wherein the side of the object extends in a direction perpendicular to the rotation axis of the reel , wherein the moving section is configured to select a storage section accommodating the external dimensions of the object that were acquired by the dimension acquiring section, and is configured to move the object loaded in the loading section to the selected storage section. The loading section loads at least an object to be used by a board work machine to perform a given board work operation. The dimension acquiring section acquires the external dimensions of the object loaded into the loading section. The storage section stores the object. The moving section moves the loaded object into the loading section to the storage section. Advantageous Effects

The storage compartment is equipped with a loading section, a dimension acquiring section, a storage section, and a moving section. This enables the storage compartment to automatically store a loaded object in the storage section, and also acquire the external dimensions of the object to be used by a board work machine.

### Brief Description of Drawings

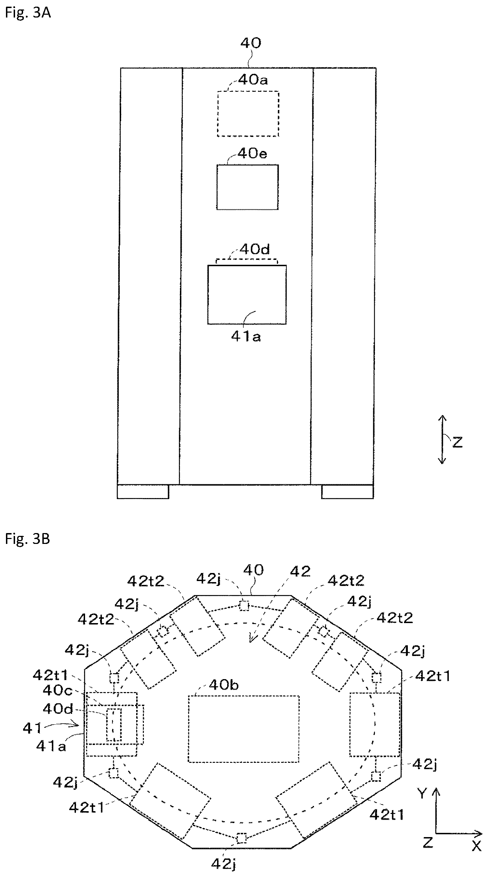

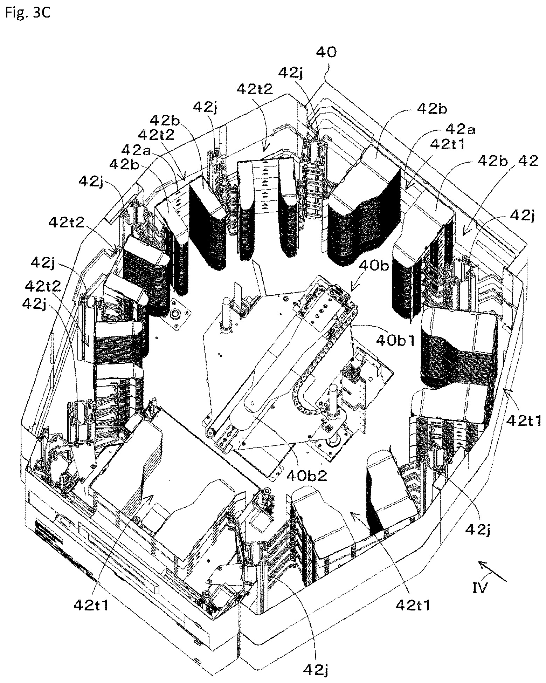

Fig. 1
   This is a configuration diagram showing a configuration example of a board production device.
Fig. 2
   This is a plan view showing an example of the state in which an object is stored in a storage case in the intake section.
Fig. 3A
   This is a front view showing an example of the storage compartment.
Fig. 3B
   This is a plan view of the storage compartment in Fig. 3A.
Fig. 3C
   This is a perspective view of the storage compartment in Fig. 3A.
Fig. 4
   This is a side view of the storage compartment in Fig. 3C in the IV arrow direction.
Fig. 5
   This is a block diagram showing an example of a control block of the storage compartment.
Fig. 6A
   This is a flowchart showing an example of a control procedure for an object loading operation.
Fig. 6B
   This is a flowchart showing an example of a control procedure for an object unloading operation.
Fig. 7A
   This is a schematic diagram showing an example of the width and depth dimensions of an object.
Fig. 7B
   This is a schematic diagram showing an example of the height dimension of an object.
Fig. 8
   This is a schematic diagram showing an example of an image captured by a first imaging device of a reel docked on a docking section.
Fig. 9
   This is a schematic diagram showing an example of an image captured by a second imaging device of a reel docked on a docking section.
Fig. 10
   This is a schematic diagram showing an example of the positional relationship between a first measuring device and a reel docked on a docking section.

### Description of Embodiments

### 1. Embodiments

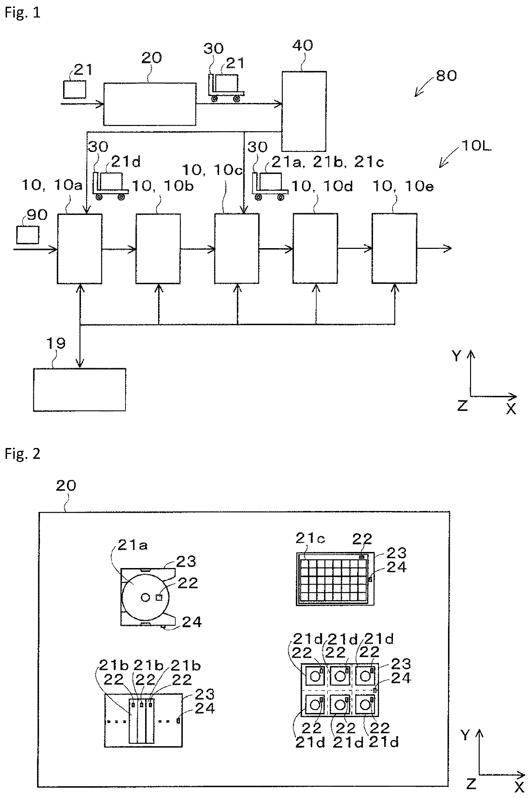

As shown in Figure 1, in this embodiment, storage compartment 40 is provided in board production device 80. Board production device 80 is provided with board work line 10L, intake section 20, conveying vehicle 30, and storage compartment 40.

### 1-1. Board work line 10L

In board work line 10L, given board work operations are performed on board 90. There are no restrictions on the type or number of board work machines 10 comprising board work line 10L. As shown in Figure 1, in this embodiment board work line 10L comprises multiple (five) board work machines 10, including: printer 10a, print inspecting device 10b, component mounting device 10c, reflow oven 10d, and exterior inspecting device 10e. Board 90 is conveyed by the board conveying device to these devices in sequence.

Printer 10a prints solder at multiple component mounting positions on board 90. Solder printed on board 90 has a given viscosity and functions as bonding material to bond board 90 with components mounted on board 90. As shown in Fig. 2, solder container 21d stores solder. Solder container 21d can consist of such containers as a closed-end cylinder or tubular sealable container.

Print inspecting device 10b inspects the condition of solder printed by printer 10a. Component mounting device 10c mounts multiple components on board 90, on which solder was printed. There can be one or more component mounting devices 10c. When multiple component mounting devices 10c are provided, the operation of mounting multiple components on board 90 can be divided between the multiple component mounting devices.

Component mounting device 10c is provided with a component supplying device that supplies the components to be mounted on board 90. As shown in Fig. 2, the component supplying device can supply components using modules such as feeder 21b provided with reel 21a, and tray 21c. Component tape (carrier tape) storing components is wound around reel 21a. Reel 21a is detachably attached to feeder 21b in such a way that reel 21a can rotate. The end of component tape 21a2 is fed out as far as a component removing section provided on feeder 21b, and components are supplied in sequence.

Reel 21a can supply comparatively small components, such as chip components. Components are arranged in Tray 21c. Tray 21c can supply comparatively large components such as quad flat package (QFP) and ball grid array (BGA) components. Reflow oven 10d heats board 90 once multiple components have been mounted on board 90 using component mounting device 10c, causing the solder to melt and adhere. External inspecting device 10e inspects the mounting condition of the multiple components mounted by component mounting device 10c.

Board work line 10L conveys boards 90 to multiple (five) board work machines 10 in sequence, where they undergo production processes including inspection processes, thereby producing board products. Board work line 10L can be provided with board work machines 10 such as function inspecting devices, buffer devices, board supplying devices, board inverting devices, shield mounting devices, adhesive applying devices, and ultraviolet irradiation devices, as required.

The multiple (five) board work machines 10 and management device 19 comprising board work line 10L can communicate with each other through a wired or wireless communication section. Management device 19 controls the multiple (five) board work machines 10 that make up board work line 10L and monitors the operating state of board work line 10L. Management device 19 records control data used in controlling the multiple (five) board work machines 10. Management device 19 transmits control data of multiple (five) board work machines 10. Each of the multiple (five) board work machines 10 transmit their operating state and production status to management device 19.

### 1-2. Intake section 20 and conveying vehicle 30

When object 21 arrives at intake section 20, given intake operations are performed. After that, object 21 is stored in storage case 23, loaded into conveying vehicle 30, and conveyed to storage compartment 40, for example. After object 21 is stored in storage compartment 40, object 21 will be supplied to board work line 10L when needed.

Board work line 10L is provided with printer 10a. Solder container 21d, which stores solder, is object 21 in this case. Board work line 10L is provided with component mounting device 10c. Reel 21a, around which is wound component tape 21a2, which stores components, is object 21 in this case.

Feeder 21b, to which reel 21a is detachably attached in such a way that reel 21a can rotate, is also an object 21. Tray 21c, in which components are arranged, is also an object 21. A holding member, which holds components, is also an object 21. A holding member can be a member such as a suction nozzle or chuck. A holding member storage device (such as a nozzle station), which contains holding members, is also an object 21. Any object can be an object 21 as long as it is used by a board work machine 10 to perform given board work operations on board 90.

Object 21 is provided with ID code 22. ID code 22 records identifying information that identifies object 21. One-dimensional codes, two-dimensional codes, wireless tags, or other forms of code can be used as ID code 22. When object 21 arrives at intake section 20, an intake section 20 operator can perform operations such as using an object management device to issue identifying information. The operator can also use a barcode reader or similar tool to read a barcode provided on object 21 by its supplier (vendor). The operator can then acquire object information about the object 21 from a database containing a registry of object information relating to objects 21. From among available identifying information and object information, the operator uses an object management device to record at least identifying information to ID code 22.

The intake section 20 operator attaches ID code 22, which at least records identifying information, to object 21 and then stores object 21 in storage case 23. Storage case 23 can take various forms, as long as it can store at least one object 21. Storage case 23 is provided with specifying code 24. Specifying code 24 records specifying information for specifying storage case 23. One-dimensional codes, two-dimensional codes, wireless tags, or other forms of code can be used as specifying code 24.

When storing object 21 in storage case 23, an operator reads specifying code 24 using a reading device, and then reads ID code 22 on object 21 using a reading device. This links the specifying information that specifies which storage case 23 contains object 21 with identifying information that identifies object 21. The linked information is transmitted to the memory section of management device 19 and is recorded there.

The intake section 20 operator loads storage case 23 containing object 21 in conveying vehicle 30. Conveying vehicle 30 can be towed by the operator, for example, or by other means. An Automatic Guided Vehicle (AGV) is another possibility of towing conveying vehicle 30. Conveying vehicle 30 of this embodiment is an unmanned conveying vehicle. Board work line 10L, intake section 20, conveying vehicle 30, and storage compartment 40 can communicate with each other through a wired or wireless communication section. When object 21 is loaded into conveying vehicle 30, management device 19 issues a transport command to conveying vehicle 30. The transport command includes the transport destination of object 21. Management device 19 determines the transport destination by selecting a storage compartment 40 that is capable of storing object 21. When conveying vehicle 30 receives the transport command, it transports object 21 to the storage compartment 40 selected as the transport destination.

Conveying vehicle 30 can transport object 21 without using storage case 23. A worker can transport object 21 without using conveying vehicle 30. At least some of the operations performed by the operator can be automated using transport devices (e.g., conveyor belts), actuators (e.g., robot arms), and object management devices.

### 1-3. Storage compartment 40

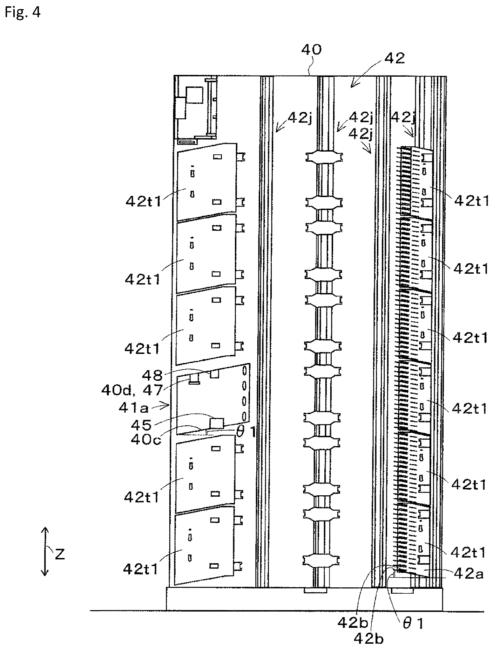

Storage compartment 40 can take various forms, as long it can store object 21. As shown in Figs. 3A to 3C, storage compartment 40 of this embodiment, for example, is in the form of an octagonal prism. In Fig. 3C, the upper section of storage compartment 40 is open, and the interior of storage compartment 40 is as shown in the drawing. Fig. 4 is a schematic diagram of the interior of storage unit 40 viewed in the direction of arrow IV shown in Fig. 3C, and mainly illustrates the positional relationship of loading section 41 and storage section 42.

Storage compartment 40 is provided with loading section 41, storage section 42, control device 40a, and movement device 40b. Loading section 41 is provided with aperture section 41a and docking section 40c. Storage section 42 is provided with two types of storage units: first storage unit 42t1 and second storage unit 42t2. Storage compartment 40 can be equipped with first imaging device 45 or first measuring device 46, and can also be equipped with second imaging device 47. Storage compartment 40 can be equipped with a second measuring device 48.

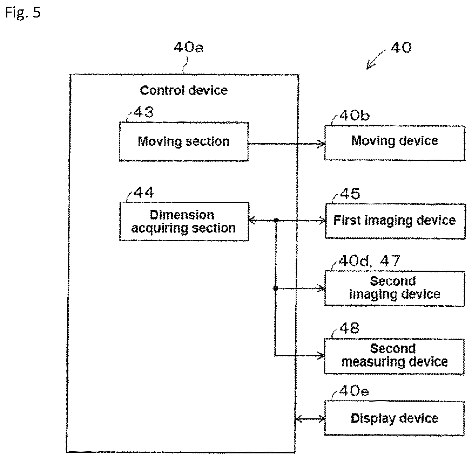

As shown in Fig. 5, when considered as a control block, control device 40a is equipped with moving section 43 and dimension acquiring section 44. Storage compartment 40 can be provided with reading device 40d. Storage compartment 40 can be provided with display device 40e. As shown in Figs. 3Aa through 3C, 4, and 5, storage compartment 40 of this embodiment is equipped with all devices and parts described above except for first measuring device 46. Second imaging device 47 also functions as reading device 40d.

### 1-3-1. Schematic configuration of storage compartment 40

Loading section 41 is equipped with aperture section 41a and docking section 40c, and loads at least object 21. As shown in Fig. 3A, aperture section 41a is provided on the front surface of storage compartment 40. Object 21 is loaded into storage compartment 40 through aperture section 41a. In this embodiment, aperture section 41a is a dual-use entry-exit aperture through which object 21 can be loaded or unloaded. Object 21 can also be unloaded through aperture section 41a. Aperture section 41a is larger than object 21 so as to enable object 21 to be loaded and unloaded.. Storage compartment 40 can be equipped with an aperture section and unloading aperture different from aperture 41a.

As shown in Figs. 3B and 4, docking section 40c is located in the work space near aperture section 41a. Object 21 is temporarily docked on docking section 40c when object 21 is loaded through aperture section 41a. When object 21 is carried in through aperture section 41a and docked on docking section 40c, the loading operation is performed by either an operator or an actuator (such as a robot arm). When object 21 is loaded through aperture section 41a, object 21 is docked on docking section 40c. Like the loading operation, object 21 docked on docking section 40c is carried out through aperture section 41a by either an operator or an actuator performing the unloading operation.

As shown in Fig. 4, reading device 40d is provided above docking section 40c. Reading device 40d acquires identifying information to identify object 21 by reading ID code 22 provided on object 21. Reading device 40d can consist of any known reading device (e.g., a code reader that reads one-dimensional or two-dimensional codes, or a wireless reader that communicates wirelessly with wireless tags). When object 21 is loaded through aperture section 41a, reading device 40d can read ID code 22 provided on object 21 and from the identifying information and object information ID code 22 contains, can at least acquire identifying information.

Storage section 42 stores object 21. Storage section 42 can take various forms, as long as it can store object 21. For example, if object 21 consists of reel 21a, it is desirable to provide storage section 42 with main body section 42a and partition section 42b, as shown in Figs. 3C and 4. Main body section 42a forms a U-shape when viewed in the vertical (Z-axis) direction. Partition section 42b protrudes upward at a given angle with respect to main body section 42a, and can store reel 21a. Partition section 42b is angled so as to keep reel 21a from falling out.

Partition sections 42b are provided in multiple pairs for each storage unit (in Fig. 4, 30 partition sections 42b making up 15 pairs) and can store multiple (15) reels 21a. Each of the multiple pairs (15 pairs) of partition sections 42b is equipped with the two partition sections 42b separated in such a way that they do not interfere with moving device 40b. In Figs. 3C and 4, for convenience, only a portion of the members have been assigned reference sign numbers, and not all members have been assigned reference sign numbers.

As shown in Figs. 3B and 3C, storage section 42 of this embodiment forms an ellipse when viewed in the vertical (Z-axis) direction. Additionally, storage section 42 of this embodiment is provided with two types of storage unit, which are first storage unit 42t1 and second storage unit 42t2. Multiple units of first storage unit 42t1 and second storage unit 42t2 are each arranged in the vertical (Z-axis) direction. First storage unit 42t1 is wider than second storage unit 42t2, and first storage unit 42t1 can hold a larger reel 21a than second storage unit 42t2 can hold.

As shown in Figs. 3C and 4, first storage unit 42t1 is connected in the vertical direction (Z-axis direction) by connecting section 42j. Second storage unit 42t2 is also connected in the vertical direction (Z-axis direction) by connecting section 42j. First storage units 42t1 which are adjacent to other first storage units 42t1 are connected via connecting sections 42j, and second storage units 42t2 which are adjacent to other second storage units 42t2 are also connected by connecting sections 42j. First storage units 42t1 which are adjacent to second storage units 42t2 are also connected by connecting sections 42j.

The type, number, and layout of storage units can be modified as needed. The shape and size (width, depth, and height) of storage units can be set to accommodate the object 21 to be stored, and storage section 42 can store objects 21 other than reels 21a. Object 21 can be stored in any compatible storage unit. If board production device 80 is equipped with multiple storage compartments 40, object 21 can be stored in any storage compartment 40 provided with a compatible storage unit.

Control device 40a is provided with a known calculation device and memory device, and is configured with control circuits. Control device 40a is configured to communicate with and control moving device 40b, second imaging device 47 which also serves as reading device 40d, display device 40e, first imaging device 45, and second measuring device 48. If storage compartment 40 is equipped with first measuring device 46 instead of first imaging device 45, control device 40a can control first measuring device 46.

Control unit 40a can record object information regarding object 21 and transmit the object information to management device 19. For example, if object 21 is reel 21a, object information can include information such as the following about the components stored on reel 21a: component type, number of components (remaining number), reel diameter (diameter D11 of reel 21a, described later), reel thickness (height H11 of reel 21a, described later), model and supplier (vendor), and expiration date.

Moving device 40b can move object 21 loaded in loading section 41 to storage section 42. In more specific terms, to load object 21, moving device 40b moves object 21 docked on docking section 40c to storage section 42. Moving device 40b can also move object 21 stored in storage section 42 to docking section 40c to unload object 21. This enables unloading of object 21.

As shown in Figs. 3B and 3C, when viewed in the vertical direction (Z-axis direction), moving unit 40b of this embodiment is located on the inner side of the storage units (first storage units 42t1 and second storage units 42t2). Moving device 40b can take various forms, as long as it can move object 21. Moving device 40b can, for example, use a robot arm (articulated robot), elevator slide mechanism, or other device. As shown in Fig. 3C, if object 21 is reel 21a, it is desirable to provide moving device 40b with elevator section 40b1 and gripping section 40b2.

Elevator section 40b1 can rotate around the axis line in the vertical direction (Z-axis direction) and can lift and lower gripping section 40b2 in the vertical direction (Z-axis direction). Gripping section 40b2 can move forward and backward at the same angle as tilt angle θ1 of the docking section 40c shown in Fig. 4. Gripping section 40b2 can also move forward and backward at the same angle as tilt angle θ1 of partition section 42b of storage section 42.

Thus, in storage compartment 40 of this embodiment, tilt angle θ1 of docking section 40c matches tilt angle θ1 of partition section 42b of storage section 42. This enables storage compartment 40 of this embodiment to perform the withdrawal operation of withdrawing reel 21a from docking section 40c when loading is performed, as well as to perform the storing operation of storing the withdrawn reel 21a in storage section 42 when loading is performed, through the actions of lifting, lowering, rotating, and moving forward and backward performed by moving unit 40b. This also enables storage compartment 40 of this embodiment to perform the withdrawal operation of withdrawing reel 21a from a storage unit when unloading is performed, as well as the sending operation of sending the withdrawn reel 21a to docking section 40c when unloading is performed, through the actions of lifting, lowering, rotating, and moving forward and backward performed by moving unit 40b.

Display device 40e enables operators to view data, and can consist of any known display device. Display unit 40e displays data such as object information about object 21 stored in storage section 42 in response to operations by the operator. Display device 40e of this embodiment is composed of a touch panel. Display device 40e also functions as an input device that is operated by the operator.

Control device 40a can record location information, loading-unloading information, and storage information of object 21 in storage section 42, and display section 40e can display this information. Location information indicates the storage location of object 21. Loading-unloading information indicates the loading and unloading dates and times of object 21. Storage information includes such information as the ambient temperature and humidity of storage section 42. Control device 40a records the location and loading date and time at which object 21 was loaded. Control device 40a records storage information while object 21 is in storage. Control device 40a records the unloading date and time at which object 21 was unloaded.

### 1-3-2. Object 21 loading-unloading control example

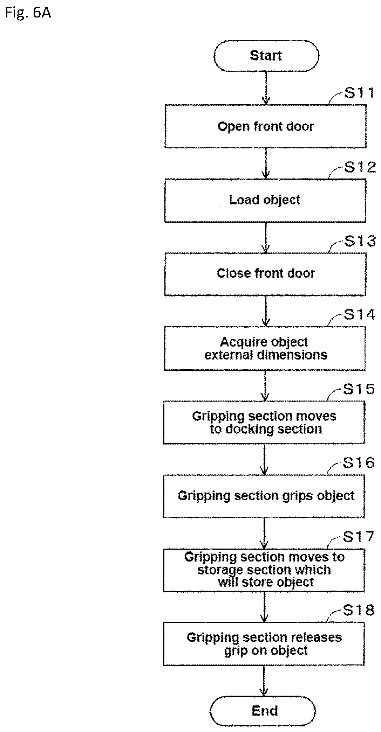

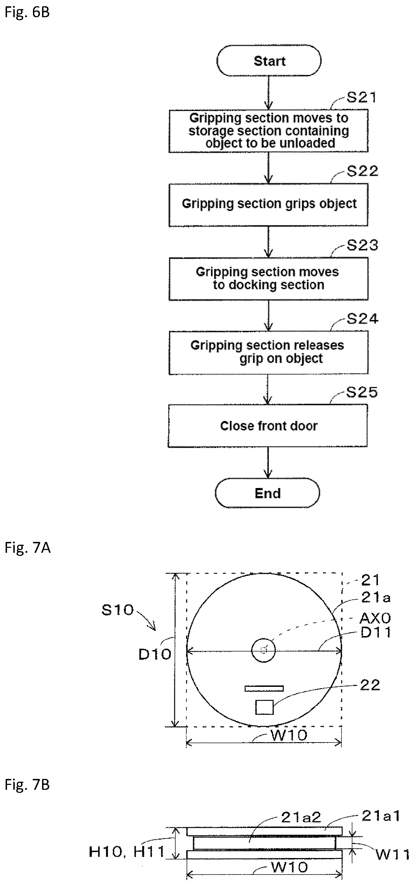

As shown in Fig. 5, when considered as a control block, control device 40a is equipped with moving section 43 and dimension acquiring section 44. Control device 40a executes control programs in accordance with the flowcharts shown in Figs. 6A and 6B. Fig. 6A shows an example of a control procedure for loading object 21. Fig. 6B shows an example of a control procedure for unloading object 21.

Moving section 43 moves object 21 loaded in loading section 41 to storage section 42. In more specific terms, when loading object 21, moving section 43 moves object 21 docked on docking section 40c to storage section 42 using moving device 40b. When unloading object 21, moving section 43 can move object 21 stored in storage section 42 to docking section 40c using moving device 40b. Moving section 43 drives and controls moving device 40b to move object 21.

A front door is provided between aperture section 41a and docking section 40c. For example, control device 40a prohibits loading and unloading of object 21 through aperture section 41a while operation is underway or when operation is scheduled to be performed during a given interval at docking section 40c of moving device 40b. At such times, control device 40a closes the front door. Conversely, control device 40a allows loading and unloading of object 21 through aperture section 41a when no operation is underway or when no operation is scheduled during a given interval at docking section 40c of moving device 40b. At such times, control device 40a opens the front door.

When loading object 21 (for example, reel 21a), an operator uses a touch panel (display device 40e functioning as an input device) to command the front door to open. Control device 40a opens the front door when object 21 loading operations are allowed (Step S11 shown in Fig. 6A). When the front door is in an open state, the operator docks reel 21a in a given location of docking section 40c via aperture section 41a (Step S12). Once reel 21a has been loaded, the operator uses the touch panel to notify control device 40a that loading is complete. Once notified that loading is complete, control device 40a closes the front door (Step S13).

Once the front door is closed, dimension acquiring section 44 acquires external dimensions S10 for reel 21a as described below (Step S14). Moving section 43 moves gripping section 40b2 of moving device 40b to docking section 40c (Step S15). In more specific terms, elevator section 40b1 of moving device 40b rotates as needed to enable gripping section 40b2 to reach reel 21a docked on docking section 40c when gripping section 40b2 moves forward, and raises gripping section 40b2 in the vertical direction (Z-axis direction). Next, gripping section 40b2 moves forward, grips reel 21a, and withdraws reel 21a while gripping reel 21a (Step S15).

After the withdrawal operation described above is completed during loading, moving section 43 moves gripping section 40b2 to the storage section 42 where reel 21a will be stored (Step S17). In more specific terms, elevator section 40b1 rotates as needed to enable gripping section 40b2 to reach a given storage location (pair of partition sections 42b containing first storage units 42t1 or second storage units 42t2) when gripping section 40b2 moves forward, and raises gripping section 40b2 in the vertical direction (Z-axis direction). Next, gripping section 40b2 moves forward and inserts reel 21a into the destination storage location (pair of partition sections 42b), releases its grip on reel 21a, and moves backward (Step S18). Performing the storing operation described above during loading stores reel 21a, which is object 21 in this case, in storage section 42.

When unloading object 21 (for example, reel 21a), an operator uses a touch panel to specify a reel 21a to be unloaded from storage compartment 40. Moving section 43 moves gripping section 40b2 to the storage section 42 in which the specified reel 21a is stored (Step S21 shown in Fig. 6B). In more specific terms, elevator section 40b1 rotates as needed to enable gripping section 40b2 to reach a reel 21a stored in a given storage location (pair of partition sections 42b) when gripping section 402b moves forward, and raises gripping section 40b2 in the vertical direction (Z-axis direction).

Next, gripping section 40b2 moves forward and grips the reel 21a stored in the storage location (pair of partition sections 42b), and moves backward while gripping reel 21a (Step S22). When unloading as described above, once the withdrawal operation is completed, moving section 43 moves gripping section 40b2 to docking section 40c (Step S23). In more specific terms, elevator section 40b1 rotates as needed to enable reel 21a gripped in gripping section 40b2 to reach docking section 40c when gripping section 402b moves forward, and raises gripping section 40b2 in the vertical direction (Z-axis direction).

Next, gripping section 40b2 moves forward, moves reel 21a to docking section 40c, releases its grip on reel 21a, and moves backward (Step S24). When unloading as described above, once the sending operation is completed, a back door provided between docking section 40c and moving device 40b is closed. Next, control device 40a opens the front door, enabling, for example, an operator to unload reel 21a through aperture section 41a (Step S25).

### 1-3-3. An example of acquiring external dimensions S10 of object 21

Dimension acquiring section 44 acquires external dimensions S10 of object 21 loaded in loading section 41 (Step S14 shown in Fig. 6A). As shown in Figs. 7A and 7B, external dimensions S10 of object 21 include width dimension W10, depth dimension D10, and height dimension H10. Dimension acquiring section 44 can take various forms, as long as it is capable of acquiring at least one of the following regarding object 21: width dimension W10, depth dimension D10, or height dimension H10.

As shown in Fig. 4, for example, storage compartment 40 of this embodiment is provided with a second measuring device 48. Second measuring device 48 measures external dimensions S10 of object 21 from above object 21 with object 21 loaded in loading section 41. Second measuring device 48 can consist of any known measuring device, such as an ultrasonic sensor, optical sensor, or three-dimensional measuring device. In this case, dimension acquiring section 44 can cause second measuring device 48 to measure object 21 with object 21 loaded in loading section 41, thereby acquiring external dimensions S10 of object 21 as measured by second measuring device 48.

As shown in Fig. 4, for example, when an ultrasonic sensor is used as second measuring device 48, second measuring device 48 sends and receives ultrasonic waves from above object 21 with object 21 docked on docking section 40c. In more specific terms, second measuring device 48 sends ultrasonic waves to object 21 in the vertical direction from a head installed above object 21. Second measuring device 48 receives, at the head, the ultrasonic waves reflected by object 21.

Second measuring device 48 measures the time it takes for the ultrasonic waves reflected by object 21 to be received from object 21 after the ultrasonic waves are sent to object 21 to measure the distance from the head to object 21. Second measuring device 48 then subtracts the measured distance from the head to object 21 from the previously acquired distance from the head to docking section 40c, and outputs the subtracted value (distance difference) as height dimension H10 of object 21. Second measuring device 48 can also measure width dimension W10 and depth dimension D10 of object 21 by moving the head in sequence above object 21, or by using multiple provided heads. The same type of measurement can be performed when using an optical sensor provided with a projector and a receiver (such as a photoelectric sensor or laser sensor).

When a three-dimensional measuring device is used as second measuring device 48, for example, second measuring device 48 beams a linear laser beam to object 21 from above object 21 with object 21 docked on docking section 40c, and receives the reflected light. Second measuring device 48 can measure the distance from the laser source to object 21 based on triangulation, and acquires the three-dimensional shape (external shape) of object 21 by moving a linear laser beam in sequence (using the optical cutting method). This enables second measuring device 48 to measure width dimension W10, depth dimension D10, and height dimension H10 of object 21.

All forms of measuring device described above enable dimension acquiring section 44 to acquire external dimensions S10 of measured object 21. However, when an ultrasonic sensor is used as a second measuring device 48, for example, dimension acquiring section 44 can experience problems in acquiring an accurate height dimension H10 of object 21 due to concave and convex areas or warping of object 21. In an embodiment in which second measuring device 48 moves the head in sequence, control of the head can be complex. If second measuring device 48 is the type which is equipped with multiple heads, it can increase device size. The same is true of optical sensors and three-dimensional measuring devices.

To address this problem, storage compartment 40 of this embodiment is provided with first imaging device 45. First imaging device 45 captures an image of object 21 from the side of object 21 with object 21 loaded in loading section 41. In this case, dimension acquiring section 44 can cause first image capturing device 45 to image object 21 loaded in loading section 41, and process the image data acquired by first image capturing device 45 to acquire height dimension H10 of object 21.

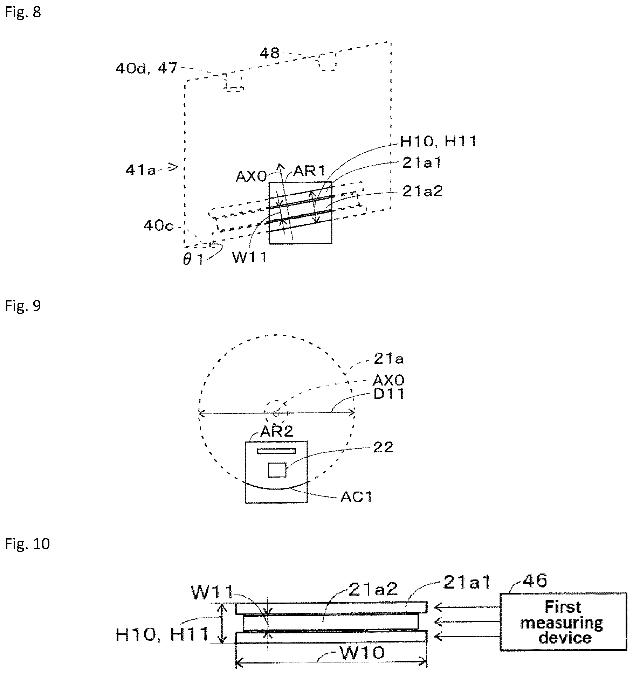

Any known imaging device can be used as the first imaging device 45 as long as it can capture an image of object 21 from the side of object 21. As shown in Fig. 4, first imaging device 45 of this embodiment is secured to a base near docking section 40c in such a way that the optical axis is perpendicular to the vertical direction. Fig. 8 shows an example of an image captured by first imaging device 45 of reel 21a docked on docking section 40c. Area AR1 shows an example of the captured field of view of first imaging device 45.

Component tape 21a2, which stores components, is wound around reel 21a, which is object 21. In more specific terms, reel 21a is provided with main body section 21a1 and component tape 21a2, and component tape 21a2 is wound around main body section 21a1. The optical axis of first imaging device 45 of this embodiment is perpendicular to rotation axis AX0 of reel 21a, and first imaging device 45 captures an image of reel 21a from the direction perpendicular to rotation axis AX0 of reel 21a. This enables the first imaging device 45 to simultaneously capture images of main body section 21a1 of reel 21a and component tape 21a2 wound around main body section 21a1.

Dimension acquiring section 44 acquires height dimension H10 of object 21 by processing image data acquired by first imaging device 45. Any known method of image processing can be used. Dimension acquiring section 44 acquires height dimension H10 of object 21 by, for example, recognizing the external shape of object 21 by such image processing methods as binarization, and using that data to measure height dimension H10 of object 21. In the example shown in Fig. 8, dimension acquiring section 44 acquires height dimension H11 of reel 21a by recognizing the external shape of main body section 21a1 of reel 21a and using that data to measure height dimension H11 of reel 21a.

The shape of main body section 21a1 of reel 21a has concave and convex areas. Main body section 21a1 of reel 21a can also become warped. The more these conditions narrow the field of view of first imaging device 45 shown in region AR1 in Fig. 8, the more difficult it is to acquire accurate height dimension H11 of reel 21a. To address this problem, dimension acquiring section 44 can acquire width dimension W11 of component tape 21a2 wound around reel 21a2, and use the acquired width dimension W11 of component tape 21a2 to estimate height dimension H11 of reel 21a.

In more specific terms, dimension acquiring section 44 acquires width dimension W11 of component tape 21a2 by recognizing the external shape of component tape 21a2 in reel 21a using image processing, and uses that data to measure width dimension W11 of component tape 21a2. In the memory device of control device 40a, the relationship between width dimension W11 of component tape 21a2 and height dimension H11 of reel 21a is recorded in advance for each width dimension W11. Dimension acquiring section 44 acquires the height dimension H11 of reel 21a which corresponds to acquired width dimension W11 of component tape 21a2 from the memory device of control device 40a. This enables dimension acquiring section 44 to estimate height dimension H11 of reel 21a based on width dimension W11 of component tape 21a2, which has less chance of varying in shape than main body section 21a1.

Storage compartment 40 can also be provided with second imaging device 47. Second imaging device 47 captures an image of reel 21a from above reel 21a with reel 21a loaded in loading section 41. In this case, dimension acquiring section 44 causes second image capturing device 47 to capture an image of at least a portion of reel 21a loaded in loading section 41, and acquires diameter D11 of reel 21a by processing the image data acquired by second image capturing device 47. As shown in Fig. 7A, diameter D11 of reel 21a corresponds to width dimension W10 of reel 21a, and depth dimension D10 of reel 21a.

Any known imaging device can be used as a second imaging device 47 as long as it can capture an image of reel 21a from above reel 21a. As shown in Fig. 4, second imaging device 47 of this embodiment is secured to a base above docking section 40c in such a way that the optical axis is in the vertical direction. Fig. 9 shows an example of an image captured by second imaging device 47 of reel 21a docked on docking section 40c. Area AR2 shows an example of the field of view of second imaging device 47.

Dimension acquiring section 44 acquires diameter D11 reel 21a by processing image data acquired by second imaging device 47. Any known method of image processing can be used. Dimension acquiring section 44 acquires diameter D11 of reel 21a by, for example, recognizing the external shape of main body section 21a1 of reel 21a by such image processing methods as binarization and measuring diameter D11 of reel 21a.

The captured image shown in Fig. 9 is a portion of reel 21a docked on docking section 40c. The captured image of the outer edge of reel 21a is shown as arc AC1. In this case, dimension acquiring section 44 cannot directly measure diameter D11 of reel 21a. To resolve this problem, dimension acquiring section 44 estimates diameter D11 of reel 21a by recognizing a portion of reel 21a (arc AC1) and using that data to calculate diameter D11 of reel 21a. In more specific terms, dimension acquiring section 44 can, for example, calculate the radius of curvature of the circle indicating the outer edge of reel 21a based on arc AC1, and use that data to estimate diameter D11 of reel 21a.

Second imaging device 47 of this embodiment also functions as reading device 40d, which reads ID code 22 attached to reel 21a. For this reason, ID code 22 is included in region AR2. This enables dimension acquiring section 44 to acquire diameter D11 of reel 21a when it acquires identifying information that identifies reel 21a. Rather than installing a second imaging device 47 separately, providing the storage compartment 40 of this embodiment reduces device size and allows efficient use of work space above docking section 40c.

As shown in Fig. 3C, storage section 42 of this embodiment is provided with two types of storage unit, which are first storage unit 42t1 and second storage unit 42t2. First storage unit 42t1 is wider than second storage unit 42t2, and first storage unit 42t1 can hold a larger reel 21a than second storage unit 42t2 can hold. In this way, storage compartment 40 of this embodiment is provided with multiple (two) types of storage section 42 to accommodate varying external dimensions S10 of object 21. In this case, moving section 43 can select a storage section 42 matching external dimensions S10 acquired by dimension acquiring section 44 regarding object 21, and move object 21 loaded in loading section 41 to the selected storage section 42.

In more specific terms, if external dimensions S10 of reel 21a acquired by dimension acquiring section 44 match first storage unit 42t1, moving section 43 selects first storage unit 42t1 as the storage section 42 to use for the reel 21a loaded in loading section 41. Next, moving section 43 uses moving device 40b to move reel 21a loaded in loading section 41 to first storage unit 42t1. Similarly, if external dimensions S10 of reel 21a acquired by dimension acquiring unit 44 match second storage unit 42t2, moving section 43 selects second storage unit 42t2 as the storage section 42 to use for reel 21a loaded in loading section 41. Next, moving section 43 uses moving device 40b to move reel 21a loaded in loading section 41 to second storage unit 42t2. The type, number, and layout of storage units is not restricted.

Setting the space between partition sections 42b that are adjacent to each other in the vertical direction based on height dimension H11 of reel 21a will improve the rate of successful storage of reels 21a in storage units, in the case of the storage units shown in Figs. 3C and 4. If reel 21a is not stored in a storage unit that matches height dimension H11 of reel 21a, gripping section 40b2 of moving device 40b can interfere with reel 21a during the storing operation when loading is performed, and during the withdrawing operation when unloading is performed.

In this case, it is best if dimension acquiring section 44 acquires height dimension H11 of reel 21a (including when it is estimated). Doing so enables moving section 43 to select a storage section 42 matching height dimension H11 of reel 21a acquired by dimension acquiring section 44, and move reel 21a loaded in loading section 41 to the selected storage section 42. This enables storage compartment 40 of this embodiment to reduce potential interference between gripping section 40b2 of moving device 40b and reel 21a during the storing operation when loading is performed, and during the withdrawing operation when unloading is performed.

### 1-4. Modified Embodiments

In any of the embodiments, storage compartment 40 can be provided with first measuring device 46 instead of first imaging device 45. First measuring device 46 measures height dimension H10 of object 21 from the side of object 21 with object 21 loaded in loading section 41. First measuring device 46 can consist of any known measuring device, such as an optical sensor provided with a light-emitting device and a light-receiving device (e.g. photoelectric sensors or laser sensors). In this case, dimension acquiring section 44 can cause first measuring device 46 to measure object 21 with object 21 loaded in loading section 41, thereby acquiring height dimension H10 of object 21 as measured by first measuring device 46.

As shown in Fig. 10, for example, when an optical sensor is used as first measuring device 46, first measuring device 46 sends a laser beam from the side of object 21 docked on docking section 40c (reel 21a in this figure), and receives the reflected light. In more specific terms, first measuring device 46 is secured to a base near docking section 40c in such a way that the optical axis is perpendicular to the vertical direction. The optical axis of first measuring device 46 is perpendicular to rotation axis AX0 of reel 21a. First measuring device 46 sends laser light to reel 21a from the direction perpendicular to rotation axis AX0 of reel 21a, and receives the reflected light.

This enables the first measuring device 46 to directly measure height dimension H10 of object 21 (height dimension H11 of reel 21a). First measuring device 46 can recognize the area around which component tape 21a2 is wound based on the difference between the distance from the light source to main body section 21a1 of reel 21a and the distance from the light source to component tape 21a2 of reel 21a, and can also directly measure width dimension W11 of component tape 21a2. In this case, dimension acquiring section 44 can acquire width dimension W11 of component tape 21a2 wound around reel 21a, and use the acquired width dimension W11 of component tape 21a2 to estimate height dimension H11 of reel 21a.

### 1-5. Other

Examples described in the embodiments and modified embodiments primarily use reel 21a to represent object 21. However, object 21 can also consist of, for example, feeder 21b, tray 21c, solder container 21d, a holding member, or a holding member storage device. Storage compartment 40 can be provided with storage units compatible with the particular object 21 to be stored, and with moving devices compatible with the particular object 21 to be moved.

### 2. Example of the Effects of the Embodiments

Depending on the storage compartment 40, storage compartment 40 is provided with loading section 41, dimension acquiring section 44, storage section 42, and moving section 43. This enables storage unit 40 to automate the storage operation of storing loaded object 21 in storage section 42, and also enables storage unit 40 to acquire external dimensions S10 of object 21 used in board work machine 10.

### Reference Signs List

10: Board work machine; 10c: component mounting device; 21: object;
21a: reel; 21a2: component tape; 22: ID code;
40: storage compartment; 40d: reading device; 41: loading section;
42: storage section; 43: moving section; 44: dimension acquiring section; 45: first imaging device;
46: first measuring device; 47: second imaging device; 48: second measuring device;
90: board; S10: external dimensions; H10, H11: height dimension;
W11: width dimension; D11: diameter; AX0: rotation axis.

## Claims

1. A storage compartment (40) comprising:
a loading section (41) configured to allow at least loading of an object (21) used by a board work machine (10) to perform given board work on a board (90); the object (21) being a reel (21a) around which a component tape (21a2) housing components is wound,
a dimension acquiring section (44) that is configured to acquire the external dimensions (S10) of the object (21) loaded in the loading section (41);
multiple types of storage section (42) configured to store objects (21) of varying external dimensions (S10); and
a moving section (43) that is configured to move the object (21) loaded in the loading section (41) to the storage section (42),
**characterized by:**
a first measuring device (46) configured to measure the height dimension (H10, H11) of the object (21) loaded in the loading section (41), the measurement taken from the side of the object (21), wherein
the dimension acquiring section (44) causes the first measuring device (46) to measure the height dimension (H10, H11) of the object (21) loaded in the loading section (41), and acquires the height dimension (H10, H11) of the object (21) measured by the first measuring device (46), wherein
the side of the object (21) extends in a direction perpendicular to the rotation axis (AX0) of the reel (21a), and
the moving section (43) is configured to select a storage section (42) accommodating the external dimensions (S10) of the object (21) that were acquired by the dimension acquiring section (44), and is configured to move the object (21) loaded in the loading section (41) to the selected storage section (42).

2. The storage compartment (40) according to Claim 1, further comprising:
a first imaging device (45) configured to capture an image of the object (21) loaded in the loading section (41), the image captured from the side of the object (21), wherein
the dimension acquiring section (44) causes the first imaging device (45) to capture an image of the object (21) loaded in the loading section (41), processes the image data acquired by the first imaging device (45), and acquires the height dimension (H10, H11) of the object (21).

3. The storage compartment (40) according to Claim 1 or Claim 2, wherein
the board work machine (10) is a component mounting device (10c) which is configured to mount components on the board (90).

4. The storage compartment (40) according to Claim 3, wherein
the dimension acquiring section (44) is configured to acquire the width dimension (W11) of the component tape (21a2) wound around the reel (21a) and is configured to use the acquired width dimension (W11) of the component tape (21a2) to estimate the height dimension (H10, H11) of the reel (21a).

5. The storage compartment (40) according to of Claim 3 or Claim 4, further comprising:
a second imaging device (47) configured to capture an image of the reel (21a) loaded in the loading section (41), the image captured from above the reel (21a), wherein
the dimension acquiring section (44) causes the second imaging device (47) to capture an image of at least a portion of the reel (21a) loaded in the loading section (41), processes the image data acquired by the second imaging device (47), and acquires the diameter (D11) of the reel (21a).

6. The storage compartment (40) according to Claim 5, wherein
the second imaging device (47) also functions as a reading device (40d) to read an identification code attached to the reel (21a).

7. The storage compartment (40) according to any one of Claim 1 to Claim 6, further comprising:
a second measuring device (48) configured to measure the external dimensions (S10) of the object (21) loaded in the loading section (41), the measurement taken from above the object (21), and wherein
the dimension acquiring section (44) causes the second measuring device (48) to measure the object (21) loaded in the loading section (41), and acquires the external dimensions (S10) of the object (21) measured by the second measuring device (48).

## Patentansprüche

1. Ein Aufbewahrungsfach (40), umfassend:
einen Ladeabschnitt (41), der konfiguriert ist, zumindest das Beladen mit einem Objekt (21) zu ermöglichen, das von einer Plattenbearbeitungsmaschine (10) verwendet wird, um bestimmte Plattenbearbeitungsvorgänge an einer Platte (90) durchzuführen; wobei das Objekt (21) eine Spule (21a) ist, um die ein Bauteilband (21a2) mit Bauteilen gewickelt ist,
einen Abmessungserfassungsabschnitt (44), der konfiguriert ist, die Außenabmessungen (S10) des in den Ladeabschnitt (41) geladenen Objekts (21) zu erfassen;
mehrere Arten von Lagerabschnitten (42), die konfiguriert sind, Objekte (21) mit unterschiedlichen Außenabmessungen (S10) lagern zu können; und
einen Bewegungsabschnitt (43), der konfiguriert ist, das im Ladeabschnitt (41) geladene Objekt (21) zum Lagerabschnitt (42) zu transportieren,
**gekennzeichnet durch:**
eine erste Messvorrichtung (46), die konfiguriert ist, die Höhenabmessung (H10, H11) des in den Ladeabschnitt (41) geladenen Objekts (21) zu messen, wobei die Messung von der Seite des Objekts (21) aus erfolgt, wobei
der Abmessungserfassungsabschnitt (44) bewirkt, dass die erste Messvorrichtung (46) die Höhenabmessung (H10, H11) des in den Ladeabschnitt (41) geladenen Objekts (21) misst, und die von der ersten Messvorrichtung (46) gemessene Höhenabmessung (H10, H11) des Objekts (21) erfasst, wobei
sich die Seite des Objekts (21) in einer Richtung senkrecht zur Drehachse (AX0) der Spule (21a) erstreckt, und
der Bewegungsabschnitt (43) konfiguriert ist, einen Lagerabschnitt (42) auszuwählen, der die vom Abmessungserfassungsabschnitt (44) erfassten Außenabmessungen (S10) des Objekts (21) aufnimmt, und konfiguriert ist, das in den Ladeabschnitt (41) geladene Objekt (21) zu dem ausgewählten Lagerabschnitt (42) zu bewegen.

2. Das Aufbewahrungsfach (40) gemäß Anspruch 1, ferner umfassend:
eine erste Abbildungsvorrichtung (45), die konfiguriert ist, ein Bild des in den Ladeabschnitt (41) geladenen Objekts (21) aufzunehmen, wobei das Bild von der Seite des Objekts (21) aufgenommen wird, wobei
der Abmessungserfassungsabschnitt (44) bewirkt, dass die erste Abbildungsvorrichtung (45) ein Bild des in den Ladeabschnitt (41) geladenen Objekts (21) aufnimmt, die von der ersten Abbildungsvorrichtung (45) erfassten Bilddaten verarbeitet und die Höhenabmessung (H10, H11) des Objekts (21) erfasst.

3. Das Aufbewahrungsfach (40) gemäß Anspruch 1 oder Anspruch 2, wobei
die Plattenbearbeitungsmaschine (10) eine Montagevorrichtung (10c) ist, die dazu konfiguriert ist, Bauteile auf der Platte (90) anzubringen.

4. Das Aufbewahrungsfach (40) gemäß Anspruch 3, wobei
der Abmessungserfassungsabschnitt (44) konfiguriert ist, die Breitenabmessung (W11) des um die Spule (21a) gewickelten Bauteilbands (21a2) zu erfasst, und konfiguriert ist, die erfasste Breitenabmessung (W11) des Bauteilbands (21a2) zu verwenden, um die Höhenabmessung (H10, H11) der Spule (21a) zu schätzen.

5. Das Aufbewahrungsfach (40) gemäß Anspruch 3 oder Anspruch 4, das ferner umfasst:
eine zweite Abbildungsvorrichtung (47), die dazu konfiguriert ist, ein Bild der in den Ladeabschnitt (41) geladenen Spule (21a) aufzunehmen, wobei das Bild von oberhalb der Spule (21a) aufgenommen wird, wobei
der Abmessungserfassungsabschnitt (44) bewirkt, dass die zweite Abbildungsvorrichtung (47) ein Bild von mindestens einem Teil der in den Ladeabschnitt (41) geladenen Spule (21a) aufnimmt, die von der zweiten Abbildungsvorrichtung (47) erfassten Bilddaten verarbeitet und den Durchmesser (D11) der Spule (21a) ermittelt.

6. Das Aufbewahrungsfach (40) gemäß Anspruch 5, wobei
die zweite Abbildungsvorrichtung (47) auch als Lesevorrichtung (40d) zum Lesen eines an der Spule (21a) angebrachten Identifikationscodes fungiert.

7. Das Aufbewahrungsfach (40) gemäß einem der Ansprüche 1 bis 6, das ferner umfasst:
eine zweite Messvorrichtung (48), die konfiguriert ist, die Außenabmessungen (S10) des in den Ladeabschnitt (41) eingelegten Objekts (21) zu messen, wobei die Messung von oberhalb des Objekts (21) erfolgt, und wobei
der Abmessungserfassungsabschnitt (44) bewirkt, dass die zweite Messvorrichtung (48) das in den Ladeabschnitt (41) geladene Objekt (21) misst, und die von der zweiten Messvorrichtung (48) gemessenen Außenabmessungen (S10) des Objekts (21) erfasst.

## Revendications

1. Compartiment de stockage (40) comprenant :
une section de chargement (41) configurée pour permettre au moins le chargement d'un objet (21) utilisé par une machine de traitement de cartes (10) pour effectuer un traitement de carte donné sur une carte (90), l'objet (21) étant une bobine (21a) autour de laquelle est enroulée une bande de composants (21a2) contenant des composants ;
une section d'acquisition de dimensions (44) configurée pour acquérir les dimensions externes (S10) de l'objet (21) chargé dans la section de chargement (41) ;
des sections de stockage (42) de multiples types configurées pour stocker des objets (21) de dimensions externes variables (S10) ; et
une section de déplacement (43) configurée pour déplacer l'objet (21) chargé dans la section de chargement (41) jusqu'à la section de stockage (42),
**caractérisé par :**
un premier dispositif de mesure (46) configuré pour mesurer la dimension en hauteur (H10, H11) de l'objet (21) chargé dans la section de chargement (41), la mesure étant réalisée depuis le côté de l'objet (21), dans lequel
la section d'acquisition de dimensions (44) commande au premier dispositif de mesure (46) de mesurer la dimension en hauteur (H10, H11) de l'objet (21) chargé dans la section de chargement (41), et acquiert la dimension en hauteur (H10, H11) de l'objet (21) mesurée par le premier dispositif de mesure (46), dans lequel
le côté de l'objet (21) s'étend dans une direction perpendiculaire à l'axe de rotation (AX0) de la bobine (21a), et
la section de déplacement (43) est configurée pour sélectionner une section de stockage (42) pouvant accueillir les dimensions externes (S10) de l'objet (21) qui ont été acquises par la section d'acquisition de dimensions (44), et est configurée pour déplacer l'objet (21) chargé dans la section de chargement (41) jusqu'à la section de stockage sélectionnée (42).

2. Compartiment de stockage (40) selon la revendication 1, comprenant en outre :
un premier dispositif d'imagerie (45) configuré pour capturer une image de l'objet (21) chargé dans la section de chargement (41), l'image étant capturée depuis le côté de l'objet (21), dans lequel
la section d'acquisition de dimensions (44) commande au premier dispositif d'imagerie (45) de capturer une image de l'objet (21) chargé dans la section de chargement (41), traite les données d'image acquises par le premier dispositif d'imagerie (45), et acquiert la dimension en hauteur (H10, H11) de l'objet (21).

3. Compartiment de stockage (40) selon la revendication 1 ou 2, dans lequel
la machine de traitement de cartes (10) est un dispositif de montage de composants (10c) configuré pour monter des composants sur la carte (90).

4. Compartiment de stockage (40) selon la revendication 3, dans lequel
la section d'acquisition de dimensions (44) est configurée pour acquérir la dimension en largeur (W11) de la bande de composants (21a2) enroulée autour de la bobine (21a) et est configurée pour utiliser la dimension en largeur acquise (W11) de la bande de composants (21a2) pour estimer la dimension en hauteur (H10, H11) de la bobine (21a).

5. Compartiment de stockage (40) selon la revendication 3 ou 4, comprenant en outre :
un deuxième dispositif d'imagerie (47) configuré pour capturer une image de la bobine (21a) chargée dans la section de chargement (41), l'image étant capturée depuis le dessus de la bobine (21a), dans lequel
la section d'acquisition de dimensions (44) commande au deuxième dispositif d'imagerie (47) de capturer une image d'au moins une portion de la bobine (21a) chargée dans la section de chargement (41), traite les données d'image acquises par le deuxième dispositif d'imagerie (47), et acquiert le diamètre (D11) de la bobine (21a).

6. Compartiment de stockage (40) selon la revendication 5, dans lequel
le deuxième dispositif d'imagerie (47) fonctionne également comme un dispositif de lecture (40d) pour lire un code d'identification attaché à la bobine (21a).

7. Compartiment de stockage (40) selon l'une quelconque des revendications 1 à 6, comprenant en outre :
un deuxième dispositif de mesure (48) configuré pour mesurer les dimensions externes (S10) de l'objet (21) chargé dans la section de chargement (41), la mesure étant réalisée depuis le dessus de l'objet (21), et dans lequel
la section d'acquisition de dimensions (44) commande au deuxième dispositif de mesure (48) de mesurer l'objet (21) chargé dans la section de chargement (41), et acquiert les dimensions externes (S10) de l'objet (21) mesurées par le deuxième dispositif de mesure (48).
